# EUROPEAN PATENT APPLICATION

(11) **EP 2 159 853 A2**
(43) Date of publication of application: **03.03.2010**
(21) Application number: 09167801.1
(22) Date of filing: 13.08.2009
(51) Int. Cl.: H01L 33/60, H01L 33/64, H01L 33/54, H01L 33/50

(54) **Light source device with hollow metal reflector**

(30) Priority: 25.08.2008 CN 200810304169
(71) Applicant: Foxsemicon Integrated Technology, Inc., Taiwan 350 (TW)
(72) Inventor: WANG, Chun-Wei, Taiwan 350, Miao-Li Hsien (TW); HSU, Hung-Kuang, Taiwan 350, Miao-Li Hsien (TW)
(74) Representative: Stuttard, Garry Philip

(57) **Abstract**

An exemplary light source device includes a circuit board (21), a solid state lighting element (22), and a hollow generally cylindrical metal reflector (23). The circuit board has a circuit layer (214) formed thereon. The solid state lighting element is mounted on the circuit board and electrically connected to the circuit layer. The reflector is mounted on the circuit board and insulated from the circuit layer. An inner surface (231) of the reflector surrounds the solid state lighting element and capable of reflecting and directing light from the solid state lighting element towards a side of the reflector far from the circuit board.

## Description

### BACKGROUND

### 1. Technical Field

The disclosure relates to light source devices with high heat-dissipation efficiency.

### 2. Description of Related Art

Light emitting diodes (LEDs) are easily influenced by temperature. Specifically, the electrical and optical characteristics and lifespan of LEDs are affected by temperature conditions. High working temperatures can deteriorate the internal quantum efficiency of an LED and shorten its lifespan. Furthermore, the resistance of the semiconductor of an LED generates a negative temperature coefficient, and tends to be reduced with an increase in the working temperature. Such reduced resistance correspondingly results in stronger current at given voltages as well as the generation of excessive heat. If the excessive heat is not effectively dissipated, heat accumulation can lead to deterioration of the LED.

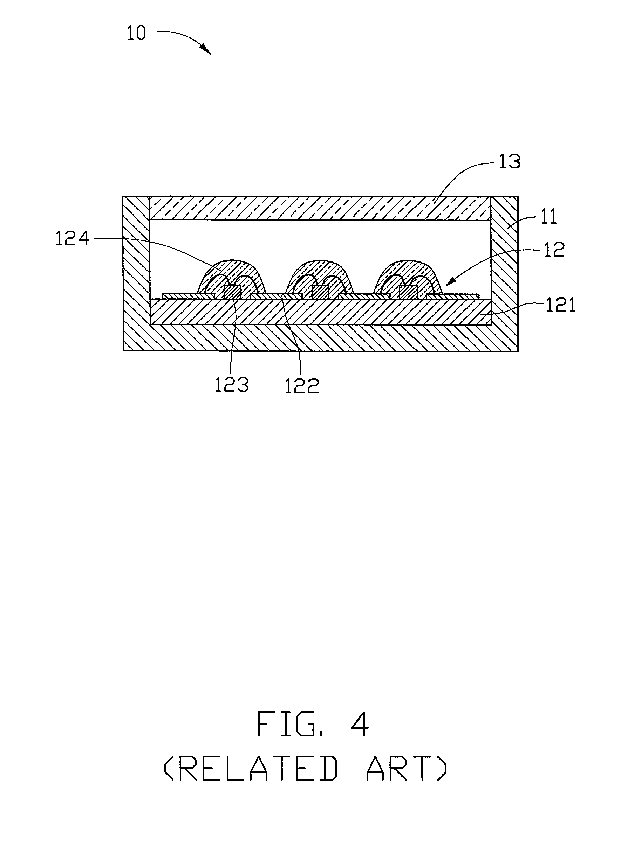

Referring to FIG. 4, a typical light source device 10 includes a shell 11, a light source module 12, and a cover 13. The light source module 12 is received in the shell 11. The cover 13 is located over and protects the light source module 12. The light source module 12 includes a printed circuit board 121, a circuit layer 122, a number of lighting elements 123 (such as LEDs), and an encapsulant 124. The circuit layer 122 and lighting elements 123 are mounted on the printed circuit board 121. The lighting elements 123 are electrically connected to the circuit layer 122. The encapsulant 124 is positioned on the printed circuit board 121 in discrete portions, so that each of the lighting elements 123 is packaged. Excessive heat from the light source module 12 can be dissipated through the shell 11. However, the thermal conductivity of the shell 11 is less than optimal, and the excessive heat is not necessarily effectively dissipated.

Therefore, there is room for improvement within the art.

### BRIEF DESCRIPTION OF THE DRAWINGS

Many aspects of the disclosure can be better understood with reference to the following drawings. The components in the drawings are not necessarily drawn to scale, the emphasis instead being placed upon clearly illustrating the principles of the disclosure. Moreover, in the drawings, all the views are schematic, and like reference numerals designate corresponding parts throughout certain of the views.

FIG. 1 is an exploded view of a first exemplary embodiment of a light source device.

FIG. 2 is an exploded view of a second exemplary embodiment of a light source device.

FIG. 3 is an exploded view of a third exemplary embodiment of a light source device.

FIG. 4 is a schematic cross-section of a typical light source device, in accordance with the related art.

### DETAILED DESCRIPTION

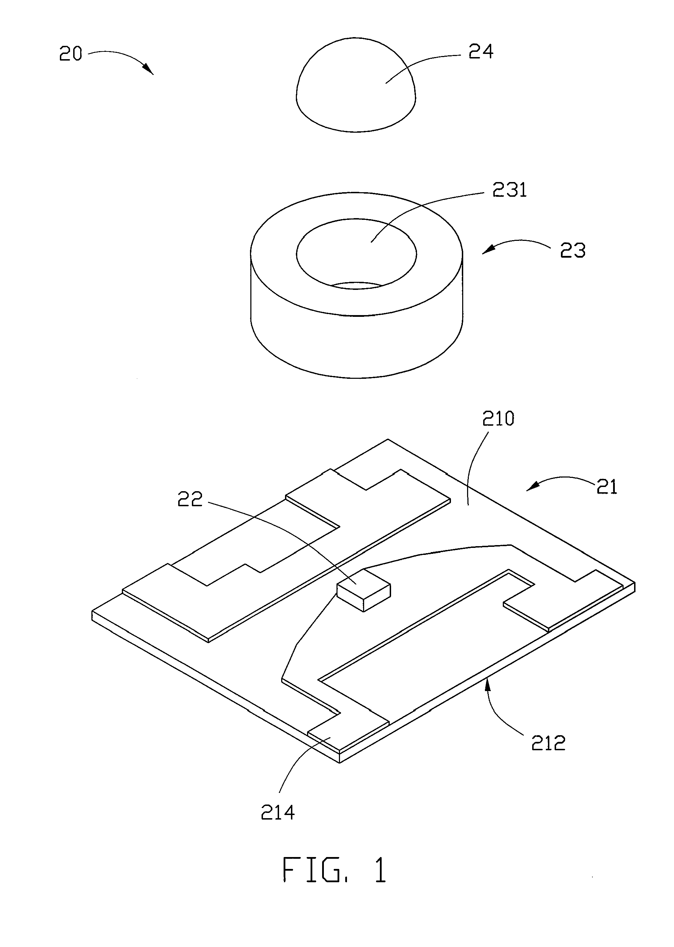

Referring to FIG. 1, a first embodiment of a light source device 20 is shown. The light source device 20 includes a circuit board 21, a solid state lighting element 22, a reflector 23, and a light-pervious encapsulant 24.

The circuit board 21 includes a first surface 210 and a second surface 212 at opposite main sides thereof. A circuit layer 214 is formed on the first surface 210 of the circuit board 21. The circuit board 21 may be made of aluminum oxide (Al₂O₃), AIN, BeO, or other ceramic materials. Alternatively, the circuit board 21 may be a silicon substrate, a metal core printed circuit board (MCPCB), etc.

In the illustrated embodiment, the solid state lighting element 22 is a light emitting diode chip (LED chip), which is arranged on the first surface 210 of the circuit board 21 and electrically connected to the circuit layer 214.

The reflector 23 has a hollow cylindrical or annular structure. The reflector 23 can be made of metal such as copper, aluminum or another suitable metal or alloy, so that the reflector 23 has good heat-dissipation efficiency. The reflector 23 is mounted on the first surface 210 of the circuit board 21 and surrounds the solid state lighting element 22. An inner peripheral surface 231 of the reflector 23 surrounding the solid state lighting element 22 reflects and directs light received from the solid state lighting element 22 towards a top side of the reflector 23, thereby changing a range of angles of light emission of the solid state lighting element 22. The reflector 23 may be connected to the circuit layer 214 via an insulating binder, so as to provide improved electrical insulation between the reflector 23 and the circuit board 21. Because the reflector 23 has good heat-dissipation efficiency, heat from the solid state lighting element 22 is effectively dissipated by the reflector 23 to the ambient environment. Thereby, the heat-dissipation efficiency of the light source device 20 is improved.

The light-pervious encapsulant 24 is received in the hollow reflector 23 and covers the solid state lighting element 22, thereby protecting the solid state lighting element 22 from mechanical damage, moisture, and other ambient contamination. The light-pervious encapsulant 24 may be a condenser lens to collect light from the solid state lighting element 22 and redirect it upwards, such that the path of light emitted from the light source device 20 can be altered. The light-pervious encapsulant 24 may be made of epoxy resin, silicone resin, or another suitable electrically insulating transparent material. The light-pervious encapsulant 24 may further include a plurality of phosphor particles doped therein. For example, when the solid state lighting element 22 is a blue LED chip, the phosphor particles can include yellow phosphors. The yellow phosphors are excited by the blue light from the solid state lighting element 22 and emit yellow light. The yellow light and some of the original blue light combine (mix) to form white light, which emits from the light-pervious encapsulant 24. The phosphor particles may include yttrium aluminum garnet (YAG) phosphor, terbium aluminum garnet (TAG) phosphor, silicate phosphor, nitride phosphor, etc.

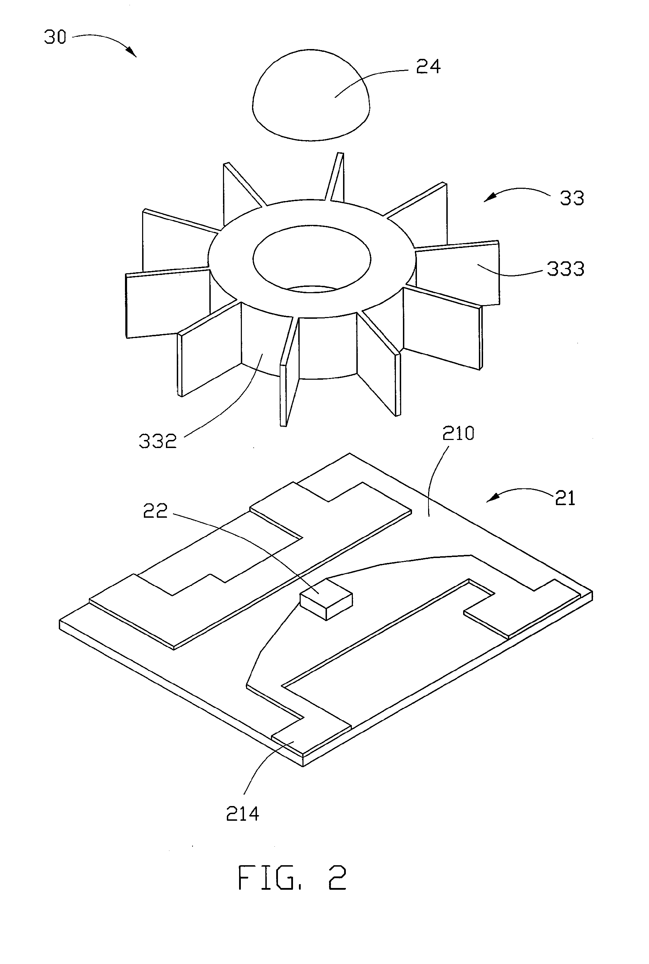

Referring to FIG. 2, a second exemplary embodiment of a light source device 30 is similar to the light source device 20. However, in the light source device 30, a plurality of fins 333 radially extends from an outer surface 332 of a reflector 33. Therefore a heat radiating area of the reflector 33 is increased, and a heat-dissipation efficiency of the light source device 30 is improved. The fins 333 may be connected to the circuit layer 214 via an insulating binder, so as to form an electrically insulated connection between the fins 333 and the circuit layer 214. Alternatively, the fins 333 may be isolated from the circuit layer 214 by air space.

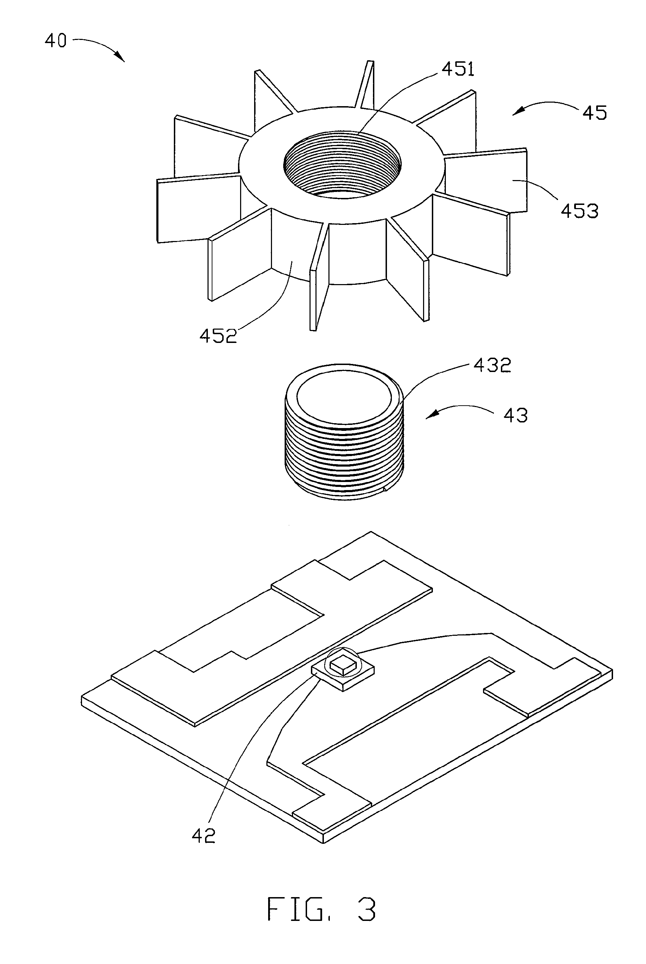

Referring to FIG. 3, a third exemplary embodiment of a light source device 40 is similar to the light source device 20 of the first embodiment, except that the light source device 40 includes an inner reflector 43 and an outer heat conductor 45.

The reflector 43 differs from the reflector 23 of the first embodiment in that an outer surface 432 of the reflector 43 has a screw thread thereon.

The heat conductor 45 differs from the reflector 23 of the first embodiment as follows. An inner surface 451 of the heat conductor 45 has an inner screw thread thereon, and a plurality of fins 453 radially extends from an outer surface 452 of the heat conductor 45. Thus the heat conductor 45 can be threadingly engaged with the reflector 43 to surround the reflector 43, if desired. Alternatively, the heat conductor 45 can be selectively omitted from the assembly of the light source device 40. Accordingly, the light source device 40 has flexibility to adapt to different application requirements. The heat conductor 45 and the reflector 43 have good heat-dissipation efficiency. That is, heat from a solid state lighting element 42 is effectively dissipated by the reflector 43 and the heat conductor 45 away from the solid state lighting element 42, thereby improving the heat-dissipation efficiency of the light source device 40. In alternative embodiments, the heat conductor 45 may be mechanically engaged with the reflector 43 in other ways. For example, the heat conductor 45 may be coiled around the reflector 43, with an inner surface of the heat conductor 45 contacting an outer surface of the reflector 43. With such alternative interengaging means, the heat conductor 45 is likewise detachably mounted to the reflector 43. In addition, in the present embodiment, the solid state lighting element 42 is a light emitting diode.

It is believed that the present embodiments and their advantages will be understood from the foregoing description, and it will be apparent that various changes may be made thereto without departing from the spirit and scope of the embodiments or sacrificing all of their material advantages.

## Claims

1. A light source device comprising:
a circuit board with a circuit layer formed thereon;
a solid state lighting element mounted on the circuit board and electrically connected to the circuit layer; and
a hollow generally cylindrical metal reflector mounted on the circuit board and insulated from the circuit layer, wherein an inner surface of the reflector surrounds the solid state lighting element and is capable of reflecting and directing light from the solid state lighting element towards a side of the reflector far from the circuit board.

2. A light source device as claimed in claim 1, wherein a plurality of fins radially extends from an outer surface of the reflector, wherein the fins are insulated from the circuit layer.

3. A light source device as claimed in claim 1 or 2, wherein the reflector comprises two parts attached to each other being a hollow generally cylindrical inner part and a hollow outer part detachably engaged with and surrounding the inner part, wherein the outer part has a plurality of fins radially extending from an outer surface thereof, wherein the inner part is mounted on the circuit board and insulated from the circuit layer and wherein the fins are insulated from the circuit layer.

4. A light source device as claimed in claim 3 wherein the outer part is threadingly engaged with the inner part.

5. A light source device as claimed in any preceding claim, wherein the circuit board is a metal core printed circuit board.

6. A light source device as claimed in any preceding claim, wherein the solid state lighting element comprises a light emitting diode chip.

7. A light source device as claimed in any preceding claim wherein the solid state lighting element comprises a light emitting diode.

8. A light source device as claimed in claim 1 further comprising a light-pervious encapsulant at least partly received in the reflector and covering the solid state lighting element.

9. A light source device as claimed in claim 8, wherein the encapsulant comprises a plurality of phosphor particles doped therein.

10. A light source device as claimed in claim 9, wherein the phosphor particles comprise material selected from the group consisting of yttrium aluminum garnet (YAG) phosphor, terbium aluminum garnet (TAG) phosphor, silicate phosphor and nitride phosphor.

11. A light source device comprising:
a circuit board with a circuit layer formed thereon;
a solid state lighting element mounted on the circuit board and electrically connected to the circuit layer;
a generally annular metal reflector attached on the circuit board and electrically isolated from the circuit layer, wherein the reflector comprises an inner side wall surrounding the solid state lighting element which is capable of reflecting and directing light from the solid state lighting element towards a top end of the reflector.

12. A light source device as claimed in claim 11, wherein a plurality of fins radially extends from an outer surface of the reflector, wherein the fins are insulated from the circuit layer.

13. A light source device as claimed in claim 11, wherein the reflector comprises two parts attached to each other being a hollow generally cylindrical inner part and a hollow outer part detachably engaged with and surrounding the inner part, wherein the outer part has a plurality of fins radially extending from an outer surface thereof, wherein the inner part is mounted on the circuit board and insulated from the circuit layer and wherein the fins are insulated from the circuit layer.

14. A light source device as claimed in claim 13, wherein the outer part is threadingly engaged with the inner part.

15. A light source device as claimed in any of claims 11 to 14, wherein the solid state lighting element is one of a light emitting diode chip and a light emitting diode.
